Europäisches Patentamt

European Patent Office

Office européen des brevets

(11) Publication number: **0 415 343 A2**

# EUROPEAN PATENT APPLICATION

(21) Application number: 90116466.5

(51) Int. Cl.⁵: **H01L 21/58**

(22) Date of filing: 28.08.90

(30) Priority: 28.08.89 JP 220848/89

(43) Date of publication of application:
06.03.91 Bulletin 91/10

(84) Designated Contracting States:
**DE FR GB NL**

(71) Applicant: **SUMITOMO ELECTRIC INDUSTRIES, LIMITED**
5-33, Kitahama 4-chome Chuo-ku
Osaka(JP)

(72) Inventor: Fujihira, Mitsuaki, c/o Yokohama
Works of Sumitomo

Electric Industries, Ltd., 1, Taya-cho,
Sakae-ku
Yokohama-shi, Kanagawa(JP)
Inventor: Tanaka, Yoshiaki, c/o Yokohama
Works of Sumitomo
Electric Industries, Ltd., 1, Taya-cho,
Sakae-ku
Yokohama-shi, Kanagawa(JP)

(74) Representative: Lehn, Werner, Dipl.-Ing. et al
Hoffmann, Eitle & Partner Patentanwälte
Arabellastrasse 4
W-8000 München 81(DE)

(54) **Integrated circuit device and method for manufacturing the same.**

(57) An integrated circuit device having an electronic circuit component (8, 9) connected by wire-bonding is characterized in that a masking member (7) having a smaller sputtering rate than that of a material forcing electrodes to be used for the wire-bonding is arranged around the electronic circuit component (8, 9). A method for manufacturing an integrated circuit device having an electronic circuit component (8, 9) connected by wire-bonding is characterized in that a masking member (7) having a smaller sputtering rate than that of material forming electrodes to be used for the wire-bonding is arranged around the electronic circuit component (8, 9).

**Fig. 3**

# INTEGRATED CIRCUIT DEVICE AND METHOD FOR MANUFACTURING THE SAME

## Background of the Invention

The present invention relates to an integrated circuit device having an electronic circuit component connected by wire-bonding and a method for manufacturing the device.

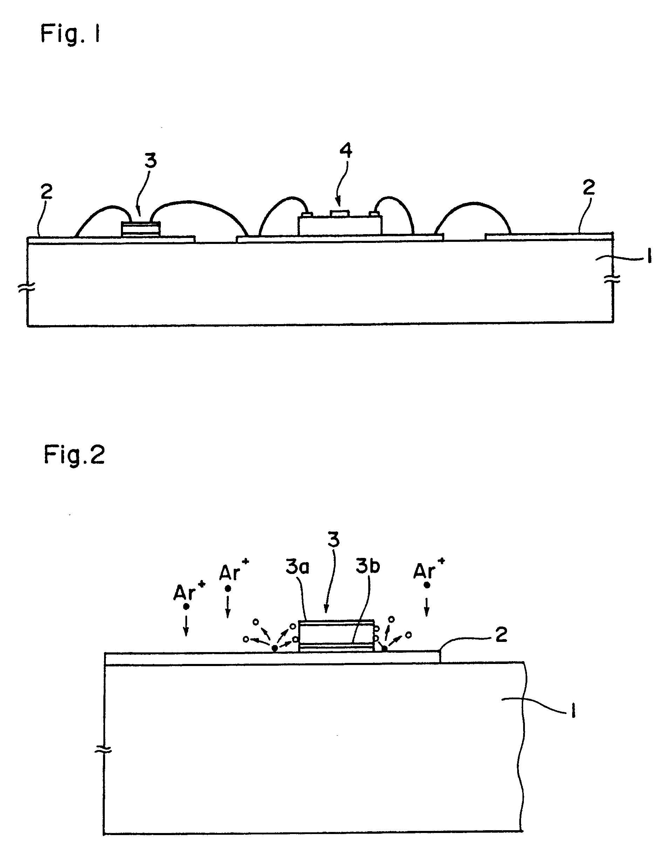

In a prior art integrated circuit, as shown in Fig. 1, a conductive pattern 2 is printed on a substrate 1, and electronic circuit components such as a parallel-plate capacitor 3 and an IC Chip 4 are connected on the conductive pattern 2. Parallel-plate capacitor 3 and IC Chip 4 or similar are connected to each other by wire-bonding either directly or through the conductive pattern 2. When these electronic circuit components are to be connected on the conductive pattern 2, a resin bonding material consisting primarily of epoxy or polyimide, solder or brazing material such as Au-Si or Au-Sn is used.

However, where the resin bonding material is used, electrodes are contaminated by organic material when the resin is heated and cured. Where solder is used, the electrodes are contaminated by flux, and where brazing material such as Au-Si is used, the surfaces of the electrodes are modified or oxide films are formed thereon because of a heating process at 300 to 450°C. Thus, none of the above processes attains a sufficiently high wire-bonding strength. Accordingly, prior to the wire-bonding, cleaning is done by ionized gas to remove foreign materials on the surfaces of the electrodes. A typical example of the cleaning process is a sputter cleaning process (sputter etching process) which uses Ar ions.

Fig. 2 shows an enlarged diagram of a prior art sputter cleaning process for an integrated circuit device. In this process, atoms (shown by circles) which form the conductive pattern 2 which has been sputter-etched by Ar ions (shown by dots) redeposit on side walls of the parallel-plate capacitor 3 to short-circuit the electrodes 3a and 3b.

Where the IC Chip is mounted, the atoms which form the conductive pattern redeposit on the IC Chip pattern to cause a malfunction.

## Summary of the Invention

It is an object of the present invention to prevent the redeposition of the sputter-etched atoms in order to improve yield and reliability in the manufacture of the integrated circuit device.

In order to achieve the above object, the integrated circuit having electronic circuit components connected by wire-bonding, in accordance with the present invention, is characterized in that masking materials consisting of atoms having a smaller sputtering rate than that of atoms which form the electrodes to be used for the wire-bonding (hereinafter referred to as wire-bonding electrodes ) are arranged around the electronic circuit components.

The method for manufacturing the integrated circuit device having electronic circuit components connected by wire-bonding, in accordance with the present invention, is characterized in that masking materials consisting of atoms having a smaller sputtering rate than that of the atoms which form the wire-bonding electrodes are arranged around the electronic circuit components.

The term "wire-bonding electrodes" herein used means connecting parts to which wires are connected when the wires are to be directly connected to the electronic circuit component or underlying material, such as electrodes of a parallel-plate capacitor or a conductive pattern.

In accordance with the present invention, it does not happen that the mask material is sputter-etched while the wire-bonding electrode is sputter-etched. Further, since the masking materials are arranged around the electronic circuit components, even if the underlying material (for example, conductive pattern) of the electronic circuit components is sputter-etched, the sputter-etched atoms do not reach to the electronic circuit components.

Accordingly, the yield and reliability in the manufacture of the integrated circuit device are significantly improved.

The present invention will become more fully understood from the detailed description given hereinbelow and the accompanying drawings which are given by way of illustration only, and thus are not to be considered as limiting the present invention.

Further scope of applicability of the present invention will become apparent from the detailed description given hereinafter. However, it should be understood that the detailed description and specific examples, while indicating preferred embodiments of the invention, are given by way of illustration only, since various changes and modifications within the spirit and scope of the invention will become apparent to those skilled in the art from this detailed description.

## Brief Description of the Drawings

Fig. 1 shows a side view of a prior art hybrid integrated circuit device,

Fig. 2 shows an enlarged side view for illustrating a sputter cleaning process to a portion of the prior art hybrid integrated circuits device,

Fig. 3 shows a side view of one embodiment of a hybrid integrated circuits device of the present invention,

Fig. 4 shows an enlarged diagram for illustrating a sputter cleaning process to a portion of the hybrid integrated circuits device of the embodiment,

Fig. 5 shows sputtering rates by Ar ions for various atoms,

Fig. 6 shows a side view of another embodiment of the hybrid integrated circuits device of the present invention,

Fig. 7 shows a process chart of one embodiment of a method for manufacturing a hybrid integrated circuits device of the present invention, and

Figs. 8A and 8B show side views of the device of the present invention and a prior art device.

## Description of the Preferred Embodiment

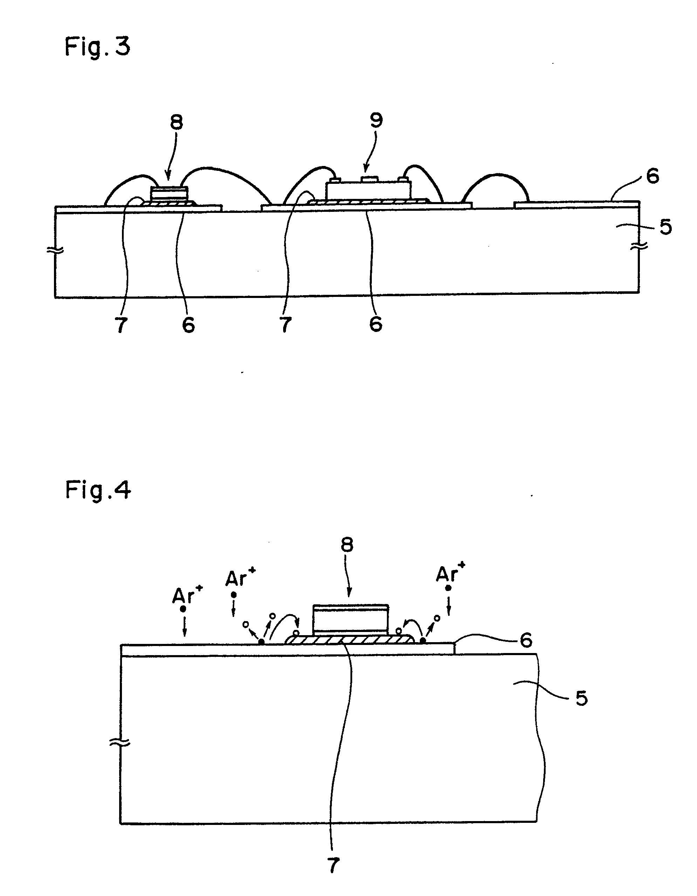

Fig. 3 shows a side view of a hybrid integrated circuits device in accordance with one embodiment of the present invention. A conductive pattern 6 is printed on a substrate 5. Electronic circuit components 8 and 9 such as parallel-plate capacitor and IC chip are connected through bonding materials (masking materials) 7 on the conductive pattern 6. A sputtering rate of the bonding material 7 is selected to be smaller than sputtering rates of the conductive pattern 6 and the wire-bonding electrode of electronic circuit components 8 and 9. The conductive pattern 6 is made of atoms whose sputtering rate is bigger than that of the wire-bonding electrode. It is important to note that the bonding materials 7 are applied with an area wider than the bottom areas of the electronic circuit components 8 and 9 and the materials (atoms) which form the bonding materials 7 have a smaller sputtering rate than that of material (atom) which forms the wire-bonding electrodes. The bonding materials 7 are arranged around the electronic circuit components 8 and 9 so that the bonding materials are prevented from being sputter-etched even if the wire-bonding electrodes are sputter-etched by a sputter cleaning method.

Fig. 4 shows an enlarged diagram illustrating the sputter cleaning process for a portion of the hybrid integrated circuits device of the present embodiment. In this process, the atoms (shown by circles) sputter-etched by the Ar ions (shown by dots) scatter around but the scattering atoms do not reach the electronic circuit components 8 because the bonding materials 7 which are formed by the atoms which are not sputter-etched by the sputter cleaning process are widely arranged around the electronic circuit components 8.

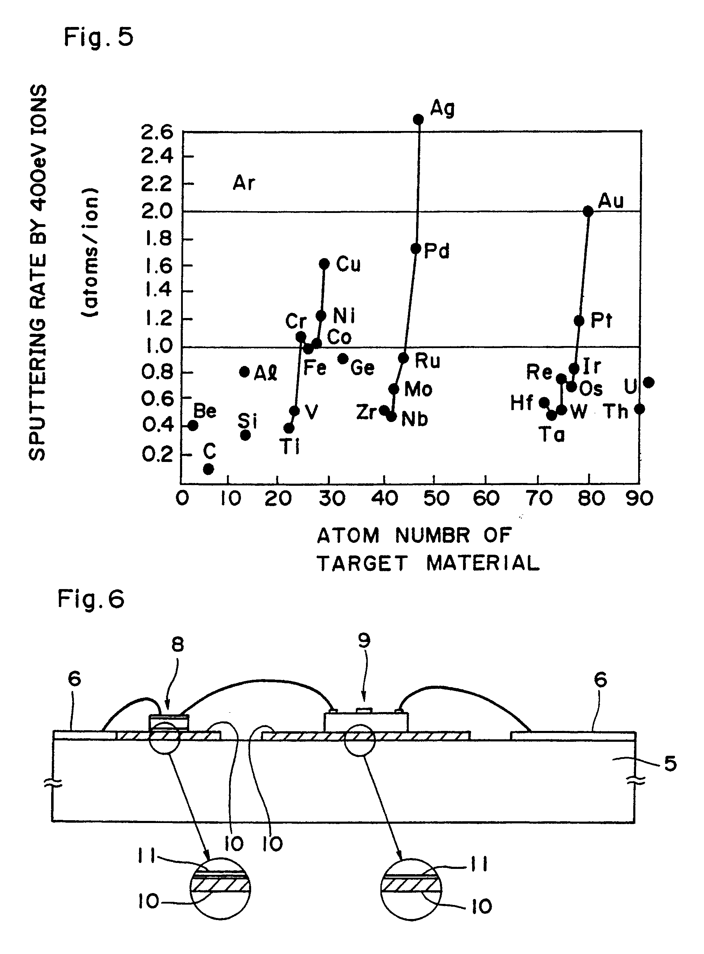

Fig. 5 shows sputtering rates by Ar ions for various atoms. For example, when Au is used as a material for the wire-bonding electrode, Si, Ge or Sn which has a smaller sputtering rate may be used as masking materials. An alloy which includes those atoms may also be used as masking materials. For example, a conventional bonding material such as epoxy resin, Au-3.15Si, Au-12Ge, or Au-20Sn may be used as masking materials. As for Au-3.15Si, approximately 20 (atomic)% of the alloy consists of Si which has one-order smaller sputtering rate than that of Au, and oxide films such as $SiO_2$ are formed on a surface in the heat bonding process. Accordingly, the sputtering rate of Au-3.15Si becomes very smaller than that of Au. The same is true for Au-12Ge and Au-20Sn.

Where Ag-Pd is used as an underlying material for the wire-bonding electrode of Au, epoxy resin or Sn-36Pb-2Ag solder may be used as a material for masking member. For example, when a combination of electrode made of Ag-Pd and masking material made of epoxy resin (Ag whose sputtering rate is higher than that of Pd forming the electrode may be added thereto) is used, the sputtering rate of the epoxy resin is much smaller than that of Ag-Pd because a main component element of the epoxy resin is C (carbon) which has a very small sputtering rate and the amount of addition of Ag, if any, is small.

Fig. 6 shows a sectional view of another embodiment of the hybrid integrated circuits device of the present invention. A difference from the above embodiment lies in the use of the conductive pattern 10 as the masking material. Conductive patterns 6 and 10 are printed on a substrate 5. A sputtering rate of the material (atom) which forms the conductive pattern 10 is selected to be smaller than the sputtering rate of the material (atom) which forms the conductive pattern 6. Further, the conductive pattern 10 is wider than the bottom area of the electronic circuit component and the material (atom) thereof has a smaller sputtering rate than the material (atom) which forms the wire-bonding electrodes. The masking materials (conductive patterns 10) are arranged around the electronic circuit components 8 and 9. As shown in the enlarged view, the electronic circuit components 8 and 9 are fixed on the conductive pattern by the bonding material 11.

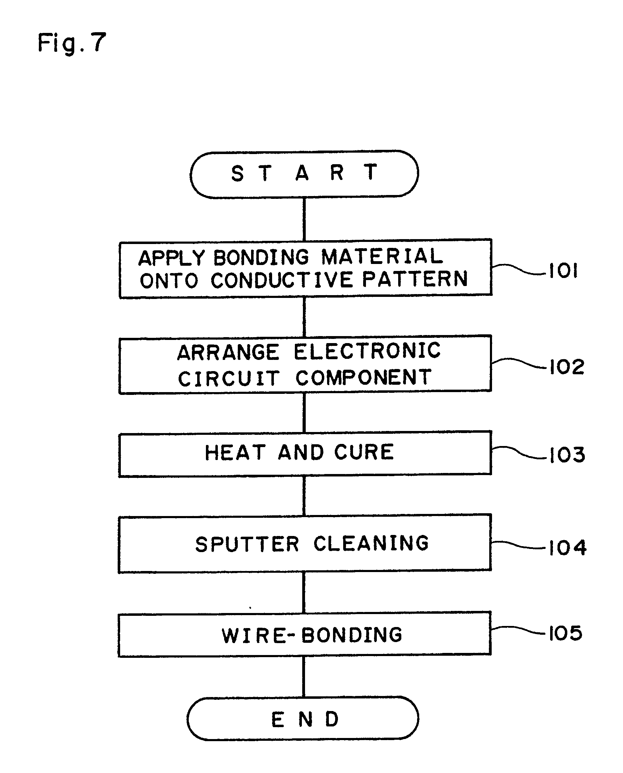

Referring to Fig. 3, a method for manufacturing the integrated circuit device in accordance with an embodiment of the present invention is now explained with reference to Fig. 7. Fig. 7 shows a process of the method for manufacturing the hybrid integrated circuits device in accordance with the present embodiment. The bonding material 7 is applied onto the conductive pattern 6 printed on the substrate 5 (step 101). The electronic circuit components 8 and 9 having wire-bonding electrodes are arranged near the center of the bonding material 7 (step 102). The electrode is made of a material (atom) whose sputtering rate is higher than that of the bonding material 7 and is lower than that of the conductive pattern 6. Further, the bonding material 7 is coated wider than the bottom area of the electronic circuit components 8 and 9. The bonding material 7 is then heated and cured (step 103) and the electronic circuit components 8 and 9 are connected to the substrate 5. In the heat and cure process, contamination by organic materials occurs in the electronic circuit components 8 and 9 such as capacitor and IC Chip and the wire-bonding electrodes of the conductive pattern 6. Accordingly, the substrate 5 is cleaned by the sputter cleaning method by the Ar ions (step 104). Since the material (atom) which forms the bonding material 7 has a smaller sputtering rate than that of the atoms which form the wire-bonding electrodes and the contaminated layer is as thin as only several tens angstroms, the contaminated layers on the wire-bonding electrodes are easily removed and the bonding materials 7 are not essentially sputter-etched even if the surfaces of the electrode materials are sputter-etched.

Further, since the bonding materials 7 are widely arranged around the electronic circuit components 8 and 9, even if the conductive pattern 6 is sputter etched, the sputter-etched atoms thereof do not reach to the electronic circuit components 8 and 9. Through the cleaning process, new clean surfaces are exposed on the surfaces of the wire-bonding electrodes. Since the wire-bonding is done to the new surfaces (step 105), the wire-bonding strength is remarkably improved.

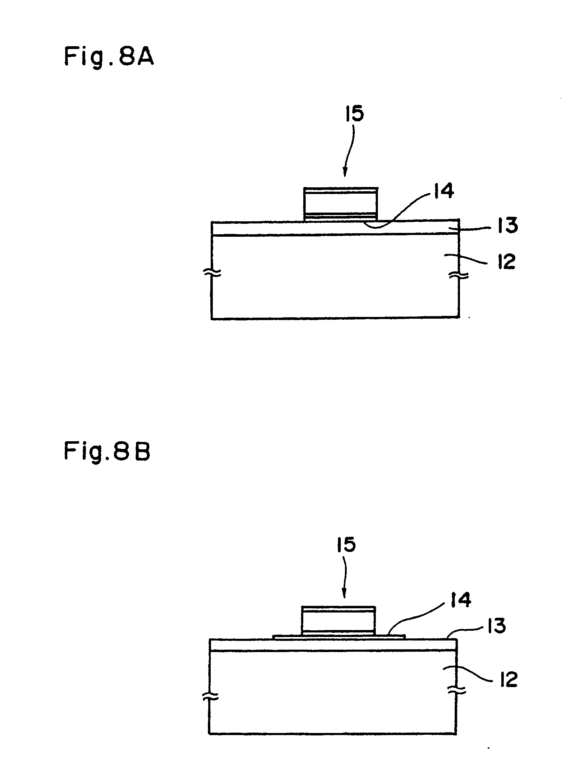

Finally, an experiment to compare the presence or absence of a short-circuit in a parallel-plate capacitor for the integrated circuit device of the present invention and a prior art integrated circuit device is explained. Figs. 8A and 8B show devices used in the experiment. Fig. 8A shows the prior art device and Fig. 8B shows the device of the present invention. Both devices have Au conductive patterns 13 printed on the substrate 12, and the parallel-plate capacitors 15 having a thickness of 100μm are connected to the conductive patterns 13 through Au-20Sn bonding materials 14. In the device of the present invention, the bonding material 14 is applied wider than the bottom area of the parallel-plate capacitor 15 so that it extends externally of the parallel-plate capacitor 15 by approximately 100μm. These devices were sputter-etched by the Ar ions for three minutes with 100w RF power. For the prior art devices, 64 out of 100 devices exhibited the short-circuit. For the devices of the present invention, none out of 100 devices exhibited the short-circuit.

From the invention thus described, it will be obvious that the invention may be varied in many ways. Such variations are not to be regarded as a departure from the spirit and scope of the invention, and all such modifications as would be obvious to one skilled in the art are intended to be included within the scope of the following claims.

## Claims

1. An integrated circuit device having an electronic circuit component connected by wires, comprising: electrodes to which said wires are to be connected; and

a masking member arranged around the electronic circuit component; and

said masking member having a smaller sputtering rate than that of material forming the electrodes.

2. An integrated circuit device according to claim 1 wherein said masking member has a wider area than the bottom area of the electronic circuit component and is interposed between the electronic circuit component and underlying member thereof.

3. An integrated circuit device according to claim 2 wherein said underlying member has a larger sputtering rate than that of the material forming the electrodes.

4. An integrated circuit device according to claim 3 wherein the area of said masking member is wide enough to prevent the atoms which scatter from the underlying member when the primary atoms conflict to the underlying member from reaching the electric circuit components.

5. An integrated circuit device according to claim 2 wherein the underlying member is a conductive film.

6. An integrated circuit device according to claim 2 wherein said masking member is a thermo-setting bonding material bondable to said electronic circuit component and said underlying member.

7. An integrated circuit device according to claim 1 wherein said masking member is epoxy resin.

8. An integrated circuit device according to claim 1 wherein said masking member is solder.

9. An integrated circuit device according to claim 1 wherein said masking member includes atom having a larger sputtering rate than that of the material forming the electrodes.

10. An integrated circuit device according to claim 1 wherein said masking member is made of conductive material.

11. A method for manufacturing an integrated circuit device having an electronic circuit component connected by wires, comprising the steps of: arranging a masking member having a smaller sputtering rate than that of a material forming electrodes to which said wires are to be connected, around said electronic circuit component; and wire-connecting said electronic circuit component by the wires.

12. A method for manufacturing an integrated circuit device according to claim 11 further comprising a step, between said mask arranging step and said wire-connecting step, of cleaning by a sputter cleaning method to said electrodes.

13. A method for manufacturing an integrated circuit device according to claim 11 wherein the masking member is arranged first in said mask arranging step and said electronic circuit component is formed on the masking member.

14. A method for manufacturing an integrated circuit device having an electronic circuit component connected by wires, comprising the steps of:

forming a pattern of a conductive film on a substrate,

forming a masking member made of thermo-setting material bondable to said electronic circuit component and said conductive film; said maaking member having a smaller sputtering rate than that of a material forming electrodes to which said wires are to be connected;

arranging said electronic circuit component on said masking member;

heating and curing said masking member to bond said electronic circuit component to said conductive film;

cleaning said electrodes by a sputter cleaning method; and

connecting the wires to said electrodes.

15. A method for manufacturing an integrated circuit device according to claim 14 wherein said masking member has a wider area than a bottom area of said electronic circuit component.

16. A method for manufacturing an integrated circuit device according to claim 14 wherein said conductive film has a larger sputtering rate than that of a material forming said electrodes.

17. A method for manufacturing an integrated circuit device according to claim 14 wherein the area of said masking member is wide enough to prevent atom scattering from the conductive film when the primary atoms conflict to said conductive film from reaching said electronic circuit component.

Fig. 1

Fig.2

Fig. 3

Fig.4

## Fig. 5

## Fig. 6

Fig. 7

```
            ┌─────────────────────┐
            │      S T A R T      │
            └─────────────────────┘
                      │
      ┌───────────────────────────────┐
      │   APPLY BONDING MATERIAL      │──── IOI
      │  ONTO CONDUCTIVE PATTERN      │
      └───────────────────────────────┘
                      │
      ┌───────────────────────────────┐
      │     ARRANGE ELECTRONIC        │──── IO2
      │     CIRCUIT COMPONENT         │
      └───────────────────────────────┘
                      │
      ┌───────────────────────────────┐
      │       HEAT AND CURE           │──── IO3
      └───────────────────────────────┘
                      │
      ┌───────────────────────────────┐
      │      SPUTTER CLEANING         │──── IO4
      └───────────────────────────────┘
                      │
      ┌───────────────────────────────┐
      │       WIRE-BONDING            │──── IO5
      └───────────────────────────────┘
                      │
            ┌─────────────────────┐
            │      E N D          │
            └─────────────────────┘
```

Fig. 8A

Fig. 8B